Europäisches Patentamt

European Patent Office

Office européen des brevets

(11) Publication number: **0 264 088 B1**

# EUROPEAN PATENT SPECIFICATION

(45) Date of publication of patent specification: **26.08.92**   (51) Int. Cl.⁵: **C04B 41/88**, H01L 21/48

(21) Application number: **87114828.4**

(22) Date of filing: **10.10.87**

(54) **Controlled atmosphere firing process.**

(30) Priority: **14.10.86 US 918303**

(43) Date of publication of application:
**20.04.88 Bulletin  88/16**

(45) Publication of the grant of the patent:
**26.08.92 Bulletin  92/35**

(84) Designated Contracting States:
**BE CH DE FR GB IT LI LU NL**

(56) References cited:
**EP-A- 0 163 548**
**EP-A- 0 186 163**
**US-A- 2 547 149**
**US-A- 4 101 952**

(73) Proprietor: **E.I. DU PONT DE NEMOURS AND COMPANY**
**1007 Market Street**
**Wilmington Delaware 19898(US)**

(72) Inventor: **McEwen, Craig Steven**
**401C West Third Street**
**Wilmington, Del.19801(US)**
Inventor: **Scrivner, Noel Charles**
**2525 Wexford Drive**
**Wilmington, Del.19810(US)**

(74) Representative: **von Kreisler, Alek,**
**Dipl.-Chem. et al**
**Deichmannhaus am Hauptbahnhof**
**W-5000 Köln 1(DE)**

## Description

The invention is directed to a process for firing oxidizable base metals in a controlled atmosphere to avoid oxidation of the base metal.

Multilayer circuits containing base metal conductors interleaved with insulating dielectric layers are made from base metal and ceramic powders, both mixed with organic binders and other organic constituents. When fired, the organic constituents must be removed while the metal must be retained in its unoxidized state.

Multilayer base metal circuits are conventionally fired one layer at a time in a nitrogen atmosphere containing up to a few hundred ppm $O_2$ to remove the organics. The metal oxide and not the metal in its elemental form is usually thermodynamically stable under these conditions. However, the rate of oxidation of the metal is usually low, especially in the relatively reducing environment created by the organic decomposition products. After the metal powder has sintered oxidation requires diffusion of the oxygen through the metal oxide layer to the bulk metal. Most of the $O_2$ in the $N_2$ atmosphere is added at lower temperatures where the diffusion rate through the metal oxide layer into the metal is relatively low. Sintering, then, partially protects the metal from oxidation when the next layer is fired on top of it.

However, a certain amount of oxidation is typical, especially when using organics that require high $O_2$ concentrations in the firing atmosphere for removal. Firing in an $O_2/N_2$ atmosphere often results in discoloration of the dielectric layer when over metal because of diffusion of metal ions and precipitation of metal atoms in the dielectric. The amount of metal oxidation and dielectric discoloration depend on the level of $O_2$ used which in turn depends on both the quantity and nature of the organics present. In general, low levels of $O_2$ give low metal oxidation but high dielectric discoloration, while high levels of $O_2$ give low dielectric discoloration but high oxidation. Optimizing the $O_2$ level under these circumstances is often difficult.

Cofiring, or simultaneous firing, of dielectric and metal layers in an $O_2/N_2$ atmosphere is even more difficult than firing the layers one at a time because longer times are required to remove the organics and since the metal layers have not been previously sintered they have little protection against this oxidizing atmosphere.

The extensive use and wide variety of controlled firing atmospheres is illustrated by the following prior art publications.

### U.S. 2,547,149, Beaudet

The patent is directed to a method of firing porcelain in which the organic content of biscuit paste is burned off in a reducing atmosphere of $CO/CO_2$ and $H_2O$.

### U.S. 3,183,588, Mathieu

Copper-alloy clad vessels are processed in a neutral or reducing atmosphere to avoid oxidation of the copper.

### U.S. 3,009,886, Wejnarth

Silicon carbide-containing resistor compositions are sintered in a reactive hydrocarbonaceous gas at 2220-2450°C.

### U.S. 3,423,517, Arrhenius

This patent is directed to monolithic ceramic electrical interconnecting structures which are fired in a reducing atmosphere such as argon containing 10% $H_2$.

### U.S. 3,615,980, Schuck et al.

The patent is directed to the decal metallization of ceramic substrates in which the decal is fired in two steps. In the first, the decal is fired in an oxidizing atmosphere to burn off the decal binder and in the second the substrate is fired in a reducing atmosphere of $H_2$ and $H_2O$ or $H_2$ and $N_2$ to effect bonding of the metal to the substrate.

2

U.S. 3,770,529, Anderson

The patent is directed to multilayer ceramic circuit structures made from green sheets in which the binder is burned off in either air or a reducing atmosphere.

U.S. 3,852,877, Ahn et al.

The patent is directed to making multilayer ceramic circuit structures from green sheets in which the binder is burned off in a reducing atmosphere of $H_2$ and $H_2O$.

U.S. 4,089,813, Alexander

The patent discloses firing $BaTiO_3$-based dielectrics in an atmosphere of $N_2$ and optionally either 2-10 mole % $H_2O$ or $H_2/CO_2$.

U.S. 4,097,911, Dorrian

The patent is directed to a method of making monolithic ceramic capacitors in which the electrodes are fired at 2500°C in a low oxygen atmosphere comprising $CO_2$ and $CO$.

U.S. 4,101,952, Burn

The reference is directed to monolithic ceramic capacitors which are sintered at 950-1080°C in a $CO_2/CO$ atmosphere to avoid oxidation of the electrode metals.

U.S. 4,234,367, Herron et al.

The patent discloses the firing of multilayer interconnected thick film circuits having copper conductors in an atmosphere of $H_2/H_2O$.

U.S. 4,504,339, Kamehara et al.

The patent discloses firing multilayered glass-ceramic structures having copper-based patterns in which firing is carried out in two steps. In the first step the binder is volatilized in an atmosphere of inert gas (N,Ar,He) and $H_2O$ and the sintering is carried out in inert gas without water.

U.S. 4,551,357, Takeuchi

The reference is directed to a method of cofiring dielectric and base metal conductor pastes in which the organic medium of the conductor paste has a higher decomposition temperature than the binder in the dielectric paste. The cofiring is carried out in two steps: (1) an oxidizing step to decompose the binder without decomposing the organic medium and (2) a low oxygen atmosphere step to decompose the organic medium. An atmosphere of $H_2 + N_2 + H_2O$ is disclosed as a suitable atmosphere for decomposing the organic medium.

Hotchkiss et al., Protective Furnace Atmospheres, Metals Handbook, 1984 Edition

This publication contains a general discussion of protective firing atmospheres and their function in annealing ferrous metals. Partly burned fuel gas is disclosed which presumably is saturated with water of combustion but also contains large amounts of $N_2$ (68.5 mole %). Other protective atmospheres discussed are hydrogen, dissociated ammonia, completely burned fuel gas and reacted fuel gas.

In its primary aspect the invention is directed to a process for firing an oxidizable base metal in the presence of an organic medium to effect volatilization of the organic medium without substantial oxidation of the metal. The process comprises heating the dispersion in an atmosphere consisting essentially of CO, $CO_2$ and from 0.1 to 90 mole % $H_2O$ basis $CO_2$, to a temperature above the thermal decomposition temperature of the organic medium and below the melting point of the base metal between the metal/metal oxide and carbon/carbon oxides phase transition lines of the resultant mixture of the atmosphere with gaseous products from decomposition of the organic medium for a time sufficient to burn out essentially all

3

EP 0 264 088 B1

of the organic medium.

In a second aspect, the invention is directed to the above-described process in which the base metal is comprised of an admixture of first and second base metals having lower and higher metal/metal oxide phase transition lines respectively and the firing temperature is between the metal/metal oxide transition lines of the base metals by which the first metal undergoes no substantial oxidation and the second metal undergoes essentially complete oxidation.

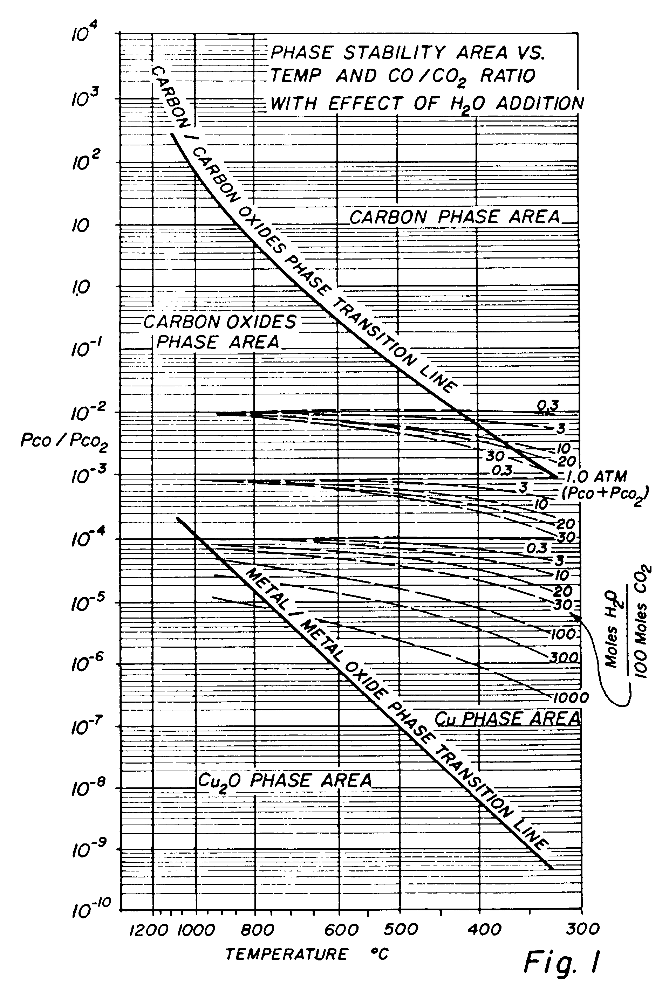

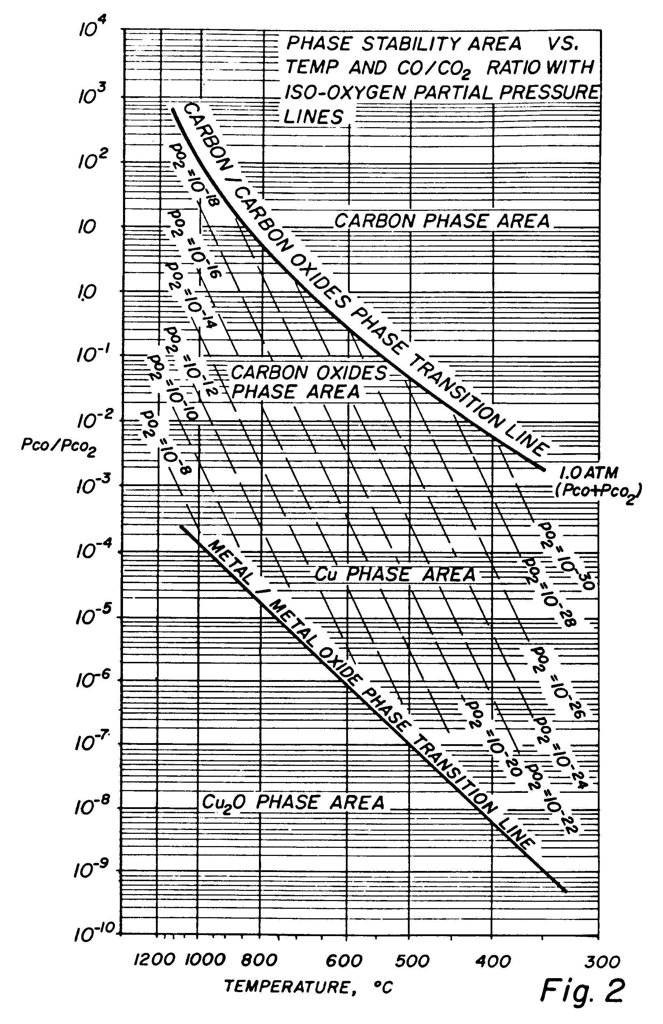

The Drawing consists of two figures of which both Figure 1 and Figure 2 are graphical representations of the phase stability area of metallic copper in an atmosphere of $CO/CO_2$ as a function of firing temperature and the ratio of the partial pressures of CO to $CO_2$. In Figure 1, the effect of $H_2O$ addition is shown and in Figure 2, lines of constant $O_2$ partial pressure are superimposed.

Detailed Description of the Invention

Firing in $O_2/N_2$ as described above is a kinetically-controlled process. That is, conditions are chosen that maximize the rate of carbon oxidation and minimize rates of metal oxidation, diffusion, and precipitation. Another approach is to use a thermodynamically-controlled process in which undesirable reaction rates are set to zero by choosing conditions under which the changes in the free energies of the undesirable reactions are positive. A $CO/CO_2$ atmosphere functions thermodynamically by controlling oxygen partial pressure. With the appropriate $CO/CO_2$ ratio, organics can be removed from the metal and dielectric layers with no metal oxidation or dielectric discoloration. There is no theoretical limit to the number of layers that can be cofired. In practice, however, relatively long times are required to remove the organics using this firing atmosphere.

Adding water to the atmosphere substantially alters the rate of organic removal without significantly changing the thermodynamic conditions preventing metal oxidation or dielectric discoloration. In short, while $CO/CO_2$ by itself is sufficient for cofiring ceramic multilayers the addition of water makes the process a practical one.

The amount of water to be added to the $CO/CO_2$ atmosphere is not itself narrowly critical. As little as 0.1 mole % water is beneficial and as much as 90 mole % $H_2O$ does not appear to be detrimental. However, no further benefit of $H_2O$ addition is apparent beyond about 30 mole % $H_2O$ addition. Moreover, $H_2O$ additions above about 5% yield only slight increases in firing rates. Thus, $H_2O$ additions of 0.1-5 mole % are preferred and, at least for copper, about 3% appears to be optimum.

The firing atmospheres for use in the invention are conveniently prepared by admixing CO and $CO_2$ gases in the desired proportions and then bubbling the admixture of gases through water in order to humidify the gases to the desired level. When using this method to add water to the $CO/CO_2$ mixture, the temperature of the water can be raised or lowered to increase or reduce the amount of water addition. When the water is added at room temperature (about 20°C), the addition of water to the $CO/CO_2$ admixture is approximately 3 mole %.

It will be recognized that the process of the invention is applicable to a wide variety of oxidizable base metal so long as their metal/metal oxide phase transition lines in a $CO/CO_2$ atmosphere lie below the carbon/carbon oxides phase transition line. Thus suitable metals include Cu, Ni and Mo, the last only above about 700°C.

Also suitable are base metals comprised of an admixture of first and second base metals having lower and higher metal/metal oxide phase transition bases respectively and the firing temperature is between the metal/metal oxide transition lines of the base metals by which the first metal undergoes essentially complete oxidation. By way of example, the oxide of the second metal may be an alloy of first and second base metals. The oxide of the second metal may be a glass former.

However oxidizable base metals such as Ti and W are not suitable for use in the invention process because their metal/metal oxide phase transition lines lie above the carbon/carbon oxides phase transition line of $CO/CO_2$ atmospheres and thus the $CO/CO_2$ atmosphere itself will precipitate carbon under these conditions.

The process of the invention can be used to fire liquid dispersions, thick film pastes or solid films such as green tapes or dry films.

Such compositions may include, for example, particles of glass frit in admixture with base metal particles. The glass may be comprised substantially of oxides which are nonreducible at the firing conditions.

Also when firing sequentially the process can be used to prevent the oxidation of already formed oxidizable metal layers adjacent to layers of other electrically functional material dispersions in organic medium. Examples of suitable organic media include a solid matrix of organic polymer and a liquid which

4

can form a dispersion of paste consistency with base metal particles.

Furthermore, it will be recognized that the process can be used in the manufacture of multilayer electronic elements such as multilayer interconnects, whether they are fired sequentially, semisequentially or cofired. The terms "electric functionality" and "electrically functional" refer to materials--either inorganic or organic--which when appropriately processed have conductive, resistive, or dielective functionality.

The oxidizable metal may also be contained in a multi-layer composite element comprising a plurality of layers of oxidizable base metal dispersion alternating with layers of finely divided particles of materials having other electric functionality dispersed in organic medium and the layers are cofired. The layer of the element may be supported on an inorganic dielectric substrate. Preferably, the substrate is alumina. It is further preferred that at least one layer of oxidizable metal dispersion is adjacent to a layer of finely divided particles of dielectric materials dispersed in organic medium and the layers are cofired. It may also be possible that at least one layer of oxidizable metal dispersion is sandwiched between layers of finely divided particles of dielectric material dispersed in organic medium and the layers are cofired. Furthermore, the layer of finely divided dielectric material dispersed in organic medium may be sandwiched between layers of oxidizable metal dispersion.

In each case it is necessary that the firing temperature be above the decomposition temperature of the organic medium in which the base metal is dispersed, but below the melting point of the base metal. The volatilization process, that is, the process of removing organic media during firing occurs in three steps: first, evaporation of lower molecular components; second, nonoxidative pyrolysis of heavier materials; and third, oxidation of the remaining materials. Thus, for most organic media the firing temperature for the process must be at least about 350 to 400°C and can, of course, be much higher to obtain more rapid and complete volatilization. As used herein the term "volatilization" means substantially complete removal of the organic medium which would normally take place as mentioned above by a combination of evaporation, oxidation and pyrolysis depending, inter alia, on the composition of the organic medium in which the base metal is dispersed.

On the other hand, the process of the invention must be carried out below the melting point of the base metal. Preferably the process is carried out at a temperature at least 50°C below the melting point of the base metal being fired. For example, in firing copper which has a melting point of 1083°C the firing temperature will normally fall within the range of 900-1025°C.

One of the advantages of the $CO/CO_2$ firing atmosphere is that it is an equilibrium-related or "buffered" system in which the $O_2$ concentration is fixed easily by adjusting the $CO/CO_2$ ratio. Thus the oxidation reduction potential of the gas admixture is easily established by adjusting the $CO/CO_2$. (As used herein the term "oxidation/reduction potential" means the tendency of the atmosphere under defining conditions either to oxidize or reduce other materials.)

In most instances it will be preferred to utilize a controlled atmosphere of $CO/CO_2$ and $H_2O$ alone so that the volume of gases which must be passed through the firing furnace can be minimized. Nevertheless it is quite feasible to use inert gas diluents in the $CO/CO_2$ and $H_2O$ atmosphere such as $N_2$ and argon. Such inert gases in some instances be used to minimize undesirable reactions in the system after the organic medium is completely removed. It will, of course, be realized by those skilled in the art that the oxidation/reduction potential of the $CO/CO_2$ atmosphere might also be expressed in terms of $O_2$ content. However, $CO/CO_2$ ratio is a more convenient expression for the oxidation/reduction potential since the term incorporates both of the process variables which are used directly to adjust the oxidation/reduction potential.

An advantage of the invention process is that it utilizes a high partial pressure of $CO_2$ (relative to $O_2$) which is the source of the oxidizing species of the $CO/CO_2$ system. The significance of this is that the diffusion transfer rate of $CO_2$ into the substrate is quite high and therefore volatilization is more complete in a given period of time. Concomitantly the $CO/CO_2$ system also has a high concentration of CO, the reducing species, which gives a high diffusion transfer rate of CO and thus maintains the base metal in the nonoxidized (bright) state. Furthermore, because the oxidative reaction of $CO_2$ is endothermic, the system is very unlikely to incur localized runaway reactions which can cause hot spots which in turn lead to unwanted entrapment of organic materials and other unwanted effects such as melting the base metal.

Turning now to Figure 1 of the drawing, it can be seen that the addition of $H_2O$ to the $CO/CO_2$ atmosphere at any given temperature results in a slight lowering of the ratio of the partial pressure of CO to $CO_2$. Furthermore, the lower the temperature the greater this lowering effect becomes. However, the amount of additional $O_2$ added to the firing atmosphere by this addition is not significant which can be seen in the following examples which show that a higher level of $H_2O$ addition and the concomitantly higher oxidation potential do not thermodynamically contribute to better burnout characteristics.

Test Procedures-Ink Adsorption

The Ink Adsorption Test is a qualitative test for estimating the degree of dielectric porosity, and thus provides a rough measure of the completeness of organic removal. The test is carried out as follows. The test piece is held horizontally. A drop of nonsmear rubber-stamp ink (Ranger Products Company, Red Bank, NJ) is placed on the dielectric surface and allowed to stand 30 seconds. The test part is then held vertically in a stream of cold tap water for 30 seconds, followed by a stream of acetone for 15 seconds, in the attempt to wash off the ink. Areas of ink retention which are traceable to distinct defects, such as blisters or dirt, should be ignored. If there is no visible ink retention on the dielectric surface, the dielectric is deemed nonporous. If there is visible ink retention on the dielectric surface, the dielectric is deemed porous.

EXAMPLES

In the following examples, the solid film of dielectric material dispersed in photosensitive organic medium used is described in Example 14 of US-A-4,613,560 (U.S Patent Application S.N. 687,460 filed December 28, 1984).

Examples 1-7

A series of seven tests was performed to observe the relative efficacy of several controlled firing atmospheres under prolonged firing times which approached equilibrium conversion levels. In each test, a solid film of copper dispersed in a photosensitive organic polymer medium and a solid film of dielectric material dispersed in a photosensitive organic polymer medium were laminated to 2.5 x 2.5 cm $Al_2O_3$ substrate squares and exposed to harden the laminated film layer. Several of these elements were then fired in each of the controlled atmospheres. The firing profile for this series of tests was two hours from room temperature to 650°C, 16 hours at 650°C and then slow cooldown by turning the furnace off.

The results of these tests are given in Table 1 below:

## Table 1

### Comparison of Firing Copper and Dielectric Elements in Various Controlled Atmospheres

| Ex. No. | Controlled Atmosphere Composition (% vol.) | Characteristics of Fired Elements |
|---|---|---|
| 1 | $N_2$ (high purity) 100 | Both elements covered with grey residue layer indicating inadequate removal of organics resulting from insufficient $O_2$ |
| 2 | $N_2/H_2O$ 97/3 | Dielectric layer clean and copper layer completely oxidized indicating excessive $O_2$ |
| 3 | $N_2/O_2$ 100/~0 (100 ppm) | Dielectric layer clean and copper layer completely oxidized indicating excessive $O_2$ |
| 4 | $CO_2$ 100 | Dielectric layer clean and copper layer completely oxidized indicating excessive $O_2$ |
| 5 | $CO/CO_2$ 0.01/~100 | Dielectric layer clean and copper layer completely oxidized indicating excessive $O_2$ |
| 6 | $CO/CO_2$ 1/99 | Dielectric layer clean and copper layer bright indicating complete removal of organics without oxidation of the Cu metal. |
| 7 | $CO/CO_2/H_2O$ 1/96/3 | Dielectric layer clean and copper layer bright indicating complete removal of organics without oxidation of the Cu metal. |

The results in Table 1 show that high-purity $N_2$ by itself has insufficient $O_2$ to volatilize the organic medium adequately. On the other hand, the addition of a small amount of $H_2O$ as an $O_2$ source gave adequate volatilization of the organic medium, but substantially completely oxidized the copper. The same result was obtained when only 100 ppm $O_2$ was added to the $N_2$. Likewise, $CO_2$ by itself gave thorough burnout (volatilization) of the medium, but over-oxidized the copper. This same effect can still be seen when 0.01% volume CO was added to the $CO_2$. This was not expected thermodynamically but is believed to have been caused by oxygen intrusion into the system. However, Examples 6 and 7 both show that when enough CO is added to the $CO_2$ the reduction potential of the gaseous mixture is sufficient completely to protect the copper from oxidation. In comparing Examples 6 and 7 there was no apparent difference in the effectiveness of $CO/CO_2$ and $Co/CO_2/H_2O$ at equilibrium. This is of course because of the long firing time used in the three tests. However, as can be seen from Examples 8 and 9 below, the addition of water has a dramatic effect in speeding up the volatilization process without altering in any significant way the favorable thermodynamics of the underlying $CO/CO_2$ atmosphere.

## Examples 8 and 9

A further test was performed in the same manner as Examples 6 and 7 in which atmospheres of $CO/CO_2$ 1/99 and $CO/CO_2/H_2O$ 1/96/3 (by volume) were used. The firing profile for these tests was one hour from room temperature to 650°C, 4 hours at 650°C and then slow cooldown by turning the furnace off.

The copper surfaces in both tests were shiny. However, from the fact that the dielectric was dirty with the use of $CO/CO_2$ alone but clearly white with $CO/CO_2/H_2O$, it was apparent that complete burnout of organic medium was accomplished more rapidly by the addition of $H_2O$ to the firing atmosphere.

## Examples 10-13

To observe the effect of various levels of $H_2O$ addition on the volatilization of organic media, a series of tests was run in which $H_2O$ addition was varied from 0 to 30 vol. %, with the same materials fired under otherwise identical conditions.

In each test, a solid film of copper dispersed in a photosensitive organic medium and a solid film of dielectric material dispersed in a photosensitive organic polymer medium were laminated to 2.5 x 2.5 cm $Al_2O_3$ substrate squares and exposed to harden the laminated film layer. Several of these laminated elements were then fired in $CO/CO_2$ atmospheres containing various levels of $H_2O$ using a firing profile of two hours from room temperature to 650°C and one hour dwell time at 650°C before turning off the furnace to effect a slow cooldown. the results of these tests are given in Table 2 below.

### Table 2

#### Effect of $H_2O$ Addition Level on Firing in $CO/CO_2$ Atmospheres

| Ex. No. | Water Bath Temperatures (°C) | $CO/CO_2/H_2O$ Proportions (% vol.) | Characteristics of the Fired Elements |
|---|---|---|---|
| 10 | – | 1/99/0 | Grey residue covering entire surface of both elements |
| 11 | 20 | 1/96/3 | Lighter colored grey residue incompletely covering surfaces of both elements |
| 12 | 47 | 1/89/10 | Lighter colored grey residue incompletely covering surfaces of both elements |
| 13 | 69 | 1/69/30 | Light colored grey residue as in Examples 9 and 10 very slightly less area covered by residue. |

These results show that at the short firing times used in this series of tests, the addition of 3% $H_2O$ to the $CO/CO_2$ atmosphere gave substantially better burnout of organics from both the copper and the dielectric. The data also show that the addition of higher amounts of $H_2O$, while not deleterious, is nevertheless not required. Though the copper surfaces were not yet shiny at these conditions, it is evident that somewhat longer firing times would yield sufficiently better burnout to obtain a completely nonoxidized copper surface.

Example 14

This example illustrates the use of the firing process of the invention in the manufacture of multilayer composite elements consisting of four copper layers alternating with three dielectric layers supported on an alumina substrate. The same conductor and dielectric materials were used as in the other Examples.

A layer of copper film dispersion was laminated to the alumina substrate and a layer of the dielectric film was laminated to the copper film and the composite structure was fired in an atmosphere of $CO/CO_2/H_2O$ 1/96/3. The firing profile was 5° per minute from room temperature to 650°C, about 16 hours at 650°C, 5° per minute up to 900°C and 10 minutes dwell time at 900°C before turning off the furnace to effect slow cooldown.

This sequence of applying two functional layers and firing was repeated three times and then a final copper layer was added by the same method. Thus, the eight-layer (including the substrate) device was made in four firing steps. The finished device had no interlayer shorts or line breaks, had no detectable stain and was hermetic as measured by the Ink Adsorption Test described hereinabove.

Example 15

This Example again illustrates the use of the firing process of the invention in the manufacture of multilayer composite elements as in Example 14. However, in this Example, the structure was made with only two firings. For the first firing, a composite supported on alumina was built up by lamination on the alumina substrate of two layers each of copper and dielectric (DE) films in the sequence Cu/DE/Cu/DE and firing the five layered laminate. For the second firing, three further layers were laminated atop the exposed dielectric layer of the first fired laminated structure in the sequence Cu/DE/Cu and the entire eight layer structure was cofired. Again, the finished device had no interlayer shorts, had no interlayer stain and was hermetic as measured by the Ink Adsorption Test.

Examples 14 and 15 along with the other examples show clearly that the controlled atmospheric firing process of the invention can be used both for sequential and cofiring of multicomponent electrically functional structures.

## Claims

1. A process for firing an oxidizable base metal in the presence of an organic medium to effect volatilization of the organic medium without substantial oxidization of the metal comprising heating the dispersion of the metal in the organic medium in an atmosphere consisting essentially of CO, $CO_2$ and from 0.1 to 90 mole % $H_2O$ basis $CO_2$, to a temperature above the thermal decomposition temperature of the organic medium and below the melting point of the base metal between the metal/metal oxide and carbon/carbon oxides phase transition lines of the resultant mixture of the atmosphere with gaseous products from decomposition of the organic medium for a time sufficient to volatilize the organic medium therefrom.

2. The process of claim 1 in which finely divided particles of the oxidizable base metal are dispersed in organic medium.

3. The process of claim 1 in which the base metal is Cu.

4. The process of claim 2 in which the organic medium is a solid matrix of organic polymer.

5. The process of claim 2 in which the organic medium is a liquid and the dispersion is of paste consistency.

6. The process of claim 2 in which the base metal is comprised of first and second base metals having lower and higher metal/metal oxide phase transition lines respectively and the firing temperature is between the metal/metal oxide transition lines of the base metals by which the first metal undergoes no substantial oxidation and the second metal undergoes essentially complete oxidation.

7. The process of claim 6 in which the oxide of the second metal is a glass former.

9

**8.** The process of claim 2 in which the particles of oxidizable base metal are in admixture with particles of glass frit.

**9.** The process of claim 8 in which the glass is comprised substantially of oxides which are nonreducible at the firing conditions.

**10.** The process of claim 6 in which the base metal is an admixture of particles of first and second base metals.

**11.** The process of claim 6 in which the base metal is an alloy of first and second base metals.

**12.** The process of claim 1 in which the oxidizable base metal is in the form of a previously fired layer adjacent to a layer of finely divided particle of electrically functional inorganic materials dispersed in organic medium.

**13.** The process of claim 2 in which the oxidizable metal is contained in a multilayer composite element comprising a plurality of layers of oxidizable base metal dispersion alternating with layers of finely divided particles of materials having other electric functionality dispersed in organic medium and the layers are cofired.

**14.** The process of claim 13 in which a layer of the element is supported on an inorganic dielectric substrate.

**15.** The process of claim 14 in which the substrate is alumina.

**16.** The process of claim 13 in which at least one layer of oxidizable metal dispersion is adjacent to a layer of finely divided particles of dielectric materials dispersed in organic medium and the layers are cofired.

**17.** The process of claim 13 in which at least one layer of oxidizable metal dispersion is sandwiched between layers of finely divided particles of dielectric material dispersed in organic medium and the layers are cofired.

**18.** The process of claim 13 in which a layer of finely divided dielectric material dispersed in organic medium is sandwiched between layers of oxidizable metal dispersion.

**Patentansprüche**

**1.** Verfahren zum Brennen eines oxidierbaren Basismetalls in Gegenwart eines organischen Mediums, um Verflüchtigung des organischen Mediums ohne erhebliche Oxidation des Metalls zu bewirken, umfassend das Erhitzen der Dispersion des Metalls in dem organischen Medium in einer Atmosphäre, die im wesentlichen besteht aus CO, $CO_2$ und 0,1 bis 90 Mol-% $H_2O$, bezogen auf $CO_2$, auf eine Temperatur oberhalb der thermischen Zersetzungstemperatur des organischen Mediums und unterhalb des Schmelzpunkts des Basismetalls zwischen den Metall/Metalloxid- und Kohlenstoff/Kohlenoxid-Phasenübergangslinien der gebildeten Mischung der Atmosphäre mit gasförmigen Produkten aus der Zersetzung des organischen Medium für hinreichend lange Zeit, um das organische Medium daraus zu verflüchtigen.

**2.** Verfahren nach Anspruch 1, wobei fein verteilte Teilchen des oxidierbaren Basismetalls in einem organischen Medium dispergiert werden.

**3.** Verfahren nach Anspruch 1, wobei das Basismetall Cu ist.

**4.** Verfahren nach Anspruch 2, wobei das organische Medium eine feste Matrix eines organischen Polymers ist.

**5.** Verfahren nach Anspruch 2, wobei das organische Medium eine Flüssigkeit ist und die Dispersion pastenartige Konsistenz aufweist.

10

6. Verfahren nach Anspruch 2, wobei das Basismetall erstes und zweites Basismetall umfaßt, die niedrigere bzw. höhere Metall/Metalloxid-Phasenübergangslinien aufweisen, und die Brenntemperatur zwischen den Metall/Metalloxid-Übergangslinien der Basismetalle liegt, bei der das erste Metall nicht wesentlich oxidiert wird und das zweite Metall im wesentlichen vollständig oxidiert wird.

7. Verfahren nach Anspruch 6, wobei das Oxid des zweiten Metalls ein Glasbildner ist.

8. Verfahren nach Anspruch 2, wobei die Teilchen des oxidierbaren Basismetalls mit Sinterglasteilchen gemischt sind.

9. Verfahren nach Anspruch 8, wobei das Glas im wesentlichen Oxide umfaßt, die unter den Brennbedingungen nicht reduzierbar sind.

10. Verfahren nach Anspruch 6, wobei das Basismetall eine Mischung aus Teilchen des ersten und zweiten Basimetalls ist.

11. Verfahren nach Anspruch 6, wobei das Basismetall eine Legierung aus erstem und zweitem Basimetall ist.

12. Verfahren nach Anspruch 1, wobei das oxidierbare Basismetall vorliegt in Form einer vorher gebrannten Schicht, die angrenzt an eine Schicht aus fein verteilten Teilchen elektrofunktioneller anorganischer Materialien, dispergiert in einem organischen Medium.

13. Verfahren nach Anspruch 2, wobei das oxidierbare Metall enthalten ist in einem mehrschichtigen Verbundelement, umfassend eine Vielzahl von Schichten einer Dispersion von oxidierbarem Basismetall, die abwechseln mit Schichten aus fein verteilten Teilchen von Materialien, die andere Elektrofunktionalität aufweisen, dispergiert in einem organischen Medium, und die Schichten gemeinsam gebrannt werden.

14. Verfahren nach Anspruch 13, wobei eine Schicht des Elements auf ein anorganisches dielektrisches Substrat aufgebracht ist.

15. Verfahren nach Anspruch 14, wobei das Substrat Aluminiumoxid ist.

16. Verfahren nach Anspruch 13, wobei wenigstens eine Schicht einer Dispersion von oxidierbarem Metall angrenzt an eine Schicht aus fein verteilten Teilchen dielektrischer Materialien, dispergiert in einem organischen Medium, und die Schichten gemeinsam gebrannt werden.

17. Verfahren nach Anspruch 13, wobei wenigstens eine Schicht einer Dispersion von oxidierbarem Metall sich sandwichartig zwischen Schichten aus fein verteilten Teilchen dielektrischen Materials, dispergiert in einem organischen Medium, befindet, und die Schichten gemeinsam gebrannt werden.

18. Verfahren nach Anspruch 13, wobei eine Schicht fein verteilten dielektrischen Materials, dispergiert in einem organischen Medium, sich sandwichartig zwischen Schichten einer Dispersion von oxidierbarem Metall befindet.

**Revendications**

1. Un procédé de cuisson d'un métal de base oxydable en présence d'un milieu organique pour effectuer la volatilisation du milieu organique sans oxydation substantielle du métal comprenant le chauffage de la dispersion du métal dans le milieu organique dans une atmosphère consistant essentiellement en $CO$, $CO_2$ et de 0,1 à 90% en moles de $H_2O$ sur la base du $CO_2$, à une température supérieure à la température de décomposition thermique du milieu organique et inférieure au point de fusion du métal de base comprise entre les courbes de transition de phases métal/oxyde métallique et carbone/oxydes de carbone du mélange résultant de l'atmosphère avec les produits gazeux issus de la décomposition du milieu organique, pendant un temps suffisant pour volatiliser ledit produit organique.

2. Le procédé selon la revendication 1, dans lequel des particules finement divisées du métal de base oxydable sont dispersées dans le milieu organique.

3. Le procédé selon la revendication 1, dans lequel le métal de base est le cuivre.

4. Le procédé selon le revendication 2, dans lequel le milieu organique est une matrice solide de polymère organique.

5. Le procédé selon la revendication 2, dans lequel le milieu organique est liquide et la dispersion a une consistance pâteuse.

6. Le procédé selon la revendication 2, dans lequel le métal de base consiste en des premier et second métaux de base ayant des courbes de transition de phases métal/oxyde métallique respectivement inférieure et supérieure et la température de cuisson est comprise entre les courbes de transition métal/oxyde métallique des métaux de base, le premier métal ne subissant substantiellement aucune oxydation et le second métal subissant une oxydation sensiblement complète.

7. Le procédé selon la revendication 6, dans lequel l'oxyde du second métal est un précurseur de verre.

8. Le procédé selon la revendication 2, dans lequel les particules de métal de base oxydable sont en mélange avec des particules d'un fritté de verre.

9. Le procédé selon la revendication 8, dans lequel le verre consiste essentiellement en des oxydes qui sont non-réductibles dans les conditions de cuisson.

10. Le procédé selon la revendication 6, dans lequel le métal de base est un mélange de particules des premier et second métaux de base.

11. Le procédé selon la revendication 6, dans lequel le métal de base est un alliage des premier et second métaux de base.

12. Le procédé selon la revendication 1, dans lequel le métal de base oxydable est sous la forme d'une couche précédemment mise à cuisson adjacente à une couche de particules finement divisées de matériaux inorganiques électriquement fonctionnels dispersés dans le milieu organique.

13. Le procédé selon la revendication 2, dans lequel le métal oxydable est contenu dans un élément composite multicouche constitué d'une pluralité de couches de dispersion de métal de base oxydable alternées avec des couches de particules finement divisées de matériaux ayant d'autres fonctionnalités électriques dispersés dans un milieu organique, et dans lequel les couches sont soumises à une co-cuisson.

14. Le procédé selon la revendication 13, dans lequel une couche de l'élément est supporté sur un substrat diélectrique inorganique.

15. Le procédé selon la revendication 14, dans lequel le substrat est l'alumine.

16. Le procédé selon la revendication 13, dans lequel au moins une couche d'une dispersion métallique oxydable est adjacente à une couche de particules finement divisées de matériaux diélectriques dispersés dans le milieu organique, et dans lequel les couches sont soumises à une co-cuisson.

17. Le procédé selon la revendication 13, dans lequel au moins une couche de la dispersion de métal oxydable est positionnée en sandwich entre des couches de particules finement divisées de matériaux diélectriques dispersés dans un milieu organique, et dans lequel les couches sont soumises à une co-cuisson.

18. Le procédé selon la revendication 13, dans lequel une couche de matériau diélectrique finement divisé dispersé dans un milieu organique est positionnée en sandwich entre des couches de dispersion de métal oxydable.

Fig. 1

Fig. 2